(19) Europäisches Patentamt
European Patent Office
Office européen des brevets

(11) **EP 4 053 924 A1**

(12) **EUROPEAN PATENT APPLICATION**

(43) Date of publication:
**07.09.2022 Bulletin 2022/36**

(21) Application number: **21160084.6**

(22) Date of filing: **01.03.2021**

(51) International Patent Classification (IPC):
**H01L 41/04** (2006.01)    **E06B 5/20** (2006.01)
**G10K 11/172** (2006.01)

(52) Cooperative Patent Classification (CPC):
**H01L 41/042; E06B 5/20; E06B 5/205;
G10K 11/172**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Saint-Gobain Glass France
92400 Courbevoie (FR)**

(72) Inventors:
• **QI, Shuibao
  60200 Compiègne (FR)**
• **BOUILLET, Fabien
  60200 Compiègne (FR)**

(74) Representative: **Saint-Gobain Recherche
B.P. 135
39, quai Lucien Lefranc
93303 Aubervilliers Cedex (FR)**

(54) **METAMATERIAL GLAZING UNIT WITH ACOUSTIC INSULATION PROPERTIES**

(57) The invention relates to an acoustic glazing unit, in particular a vehicle glazing unit or a building glazing unit. The glazing unit comprises:
- a laminated glass panel (1) comprising at least two glass sheets (3) between which is inserted at least one interlayer (4) of viscoelastic plastic material;
- an array of piezoelectric patches (2, 6) periodically arranged on at least one of the main surfaces of the laminated glass panel (1);

- a plurality of loading circuits (5) each comprising at least one negative capacitor and at least one inductor, wherein each piezoelectric patch (2, 6) is connected to a respective loading circuit (5);
wherein the negative capacitors of each loading circuit (5) have a negative capacitance $C_n$ in the range of from $-0.7 \times C_p$ to $-0.1 \times Cp$, wherein $Cp$ is the capacitance of the piezoelectric patch (2, 6) to which the loading circuit (5) is connected.

**FIG. 7**

EP 4 053 924 A1

## Description

### Technical field

The present invention relates to a glazing unit based on a metamaterial having broadband sound insulation properties.

### Technical background

In the automobile and building industries, sound insulation is an important property for glazing in order to achieve a quiet environment inside vehicles and buildings.

The behavior of sound transmission loss (STL) achieved with plate or panel structures can generally be divided into four regions depending on the frequency: a resonance-controlled region at the lowest frequencies, a mass-controlled region, a coincidence-controlled region at higher frequencies, and a stiffness-controlled region at the highest frequencies. In the coincidence-controlled region, all the incident waves can pass through the panel almost without attenuation for plain boards or planar structures, leading to a significant drop in the STL of the glazing unit.

For glass panels, the frequency band of 0.5 to 4 kHz (corresponding to frequencies to which the human ear is sensitive) generally includes the mass-controlled region and, in this frequency band, STL is governed by mass law.

Even though some solutions to improve the sound insulation performance of flat glass panels in the coincidence-controlled region have been developed (for example the coincident effect may be reduced or prevented by using laminated glass), there are very few practical and lightweight solutions for STL improvement in the mass-controlled region. Indeed, increasing the panel thickness improves the STL but leads to heavy and cumbersome structures.

Document WO 2019/229351 relates to a glazing unit comprising a transparent substrate having on at least one of its faces a network of piezoelectric transducers, each piezoelectric transducer being connected to a resonant electrical circuit such that the substrate forms a piezoelectric acoustic metamaterial. This metamaterial makes it possible to improve the STL in the mass-controlled region, around the anti-resonance frequency of the metamaterial (a *"STL peak"*, generated by band gap, is observed at the anti-resonance frequency of the glazing unit), in a lightweight and compact manner. However, with this metamaterial solution, a drop in the STL (which can be designated as an *"STL valley"*) is observed in a certain frequency band in the mass-controlled region, with the STL being degraded by the resonance of the metamaterial glazing.

There is thus a need for a glazing unit having improved sound insulation properties on a larger frequency band, and in particular improved sound insulation performance in the frequency band of 0.5 - 4 kHz, without sound transmission loss degradation, while having lightweight and compact features.

### Summary of the invention

It is a first object of the invention to provide a glazing unit comprising:

- a laminated glass panel comprising at least two glass sheets between which is inserted at least one interlayer of viscoelastic plastic material;
- an array of piezoelectric patches periodically arranged on at least one of the main surfaces of the laminated glass panel;
- a plurality of loading circuits each comprising at least one negative capacitor and at least one inductor, wherein each piezoelectric patch is connected to a respective loading circuit;

wherein the negative capacitors of each loading circuit have a negative capacitance $C_n$ in the range of from $-0.7 \times C_p$ to $-0.1 \times C_p$, wherein $C_p$ is the capacitance of the piezoelectric patch to which the loading circuit is connected.

In some embodiments, the at least one inductor is a synthetic inductor.

In some embodiments, the inductor of each loading circuit has an inductance of from 0.25 mH to 100 H, preferably from 0.01 H to 20 H.

In some embodiments, each loading circuit comprises at least one resistor.

In some embodiments, each loading circuit is a passive circuit or a semi-passive circuit.

In some embodiments, the interlayer of viscoelastic plastic material is an interlayer of polyvinyl butyral.

In some embodiments, the interlayer of viscoelastic plastic material is an interlayer of acoustic polyvinyl butyral.

In some embodiments, the piezoelectric patches are transparent, preferably the laminated glass panel is transparent.

In some embodiments, the piezoelectric patches have a thickness of from 2 $\mu$m to 2 mm, preferably from 10 $\mu$m to 200 $\mu$m.

In some embodiments, the surface area ratio of the piezoelectric patches to the laminated glass panel main surface is greater than or equal to 0.15, preferably is from 0.7 to 0.9.

In some embodiments, the negative capacitance $C_n$ of the negative capacitors of each loading circuit is in the range of from $-0.6 \times C_p$ to $-0.4 \times C_p$.

In some embodiments, the glazing unit comprises an array of piezoelectric patches periodically arranged on the two main surfaces of the laminated glass panel, preferably the piezoelectric patches on each main surface are placed opposite each other.

In some embodiments, all piezoelectric patches and all loading circuits are identical.

In some embodiments, the glazing unit comprises at least two subarrays of piezoelectric patches each periodically arranged on at least one of the main surfaces of the laminated glass panel, wherein the piezoelectric patches of each subarray are identical and connected to identical loading circuits and wherein the piezoelectric patches and/or loading circuits of the different subarrays are different from each other.

In some embodiments, the loading circuits have at least two negative capacitors of different negative capacitance $C_n$ in the range of from $-0.7 \times C_p$ to $-0.1 \times C_p$ and/or at least two inductors of different inductance.

The present invention enables to meet the abovementioned need. In particular, the invention provides a glazing unit exhibiting excellent sound insulating properties on a broader range of frequency while being relatively lightweight and compact. In particular, the glazing unit according to the invention allows an improved sound insulation in the frequency range of from 0.5 to 4 kHz.

This is achieved by the combination of the use of a periodic array of piezoelectric patches deposited on the glazing panel, each piezoelectric patch being connected to an electrical circuit comprising a negative capacitor having a specific capacitance and an inductor, and the use of laminated glass as the glazing panel.

**Brief description of the drawings**

**Figure 1** shows a schematic view of an example of pattern for the arrangement of the piezoelectric patches on the surface of the laminated glass panel according to the invention.

**Figure 2** shows a schematic view of another example of pattern for the arrangement of the piezoelectric patches on the surface of the laminated glass panel according to the invention.

**Figure 3** shows a schematic view of another example of pattern for the arrangement of the piezoelectric patches on the surface of the laminated glass panel according to the invention.

**Figure 4** shows a schematic perspective view of an example of glazing unit according to the invention. The loading circuits are not shown.

**Figure 5** shows a schematic side view of an example of glazing unit according to the invention.

**Figure 6** shows a schematic side view of another example of glazing unit according to the invention.

**Figure 7** shows a schematic side view of another example of glazing unit according to the invention.

**Figure 8** shows a schematic side view of another example of glazing unit according to the invention.

**Figure 9** shows the sound transmission loss (in dB) (y-axis) of the glazing unit No. 1 described in the example below, with the loading circuits in operation (solid black line) and with the loading circuits cut off (dotted grey line), as a function of the frequency (in kHz) (x-axis).

**Figure 10** shows the sound transmission loss (in dB) (y-axis) of the glazing unit No. 2 described in the example below, with the loading circuits in operation (solid black line) and with the loading circuits cut off (dotted grey line), as a function of the frequency (in kHz) (x-axis).

**Detailed description**

The invention will now be described in more detail without limitation in the following description.

The glazing unit of the invention comprises a laminated glass panel. By *"laminated glass panel"* is meant at least two glass sheets comprising between them at least one interlayer, generally in a viscoelastic plastic material. The interlayer in viscoelastic plastic material may comprise one or more layers of a viscoelastic polymer such as polyvinyl butyral (PVB) or a copolymer of ethylene and vinyl acetate (EVA), preferably PVB.

The interlayer may be in standard PVB or in acoustic PVB (such as monolayer acoustic PVB or tri-layer acoustic PVB). Generally, the acoustic PVB is composed of three layers: two external layers of standard PVB and one internal layer of PVB in which a plasticizer is added to make this layer less stiff and more damping than the external layers.

Preferably, the interlayer is made of acoustic PVB and in particular tri-layer acoustic PVB. The use of acoustic PVB allows a better reduction of the coincidence effect than standard PVB, *i.e.* acoustic PVB makes it possible to decrease, or even prevent, the STL drop in the coincidence-controlled region in a more efficient manner than standard PVB.

The glass sheets may independently be in organic glass or mineral glass. They may independently be in tempered glass or not.

The glass sheets of the laminated glass panel may independently have a thickness of from 0.7 mm to 19 mm, preferably from 1.6 mm to 6 mm. They may have the same thickness or a different thickness from each other.

The interlayer, preferably the PVB layer, may have a thickness of from 0.1 mm to 2 mm, preferably from 0.38 mm to 0.86 mm.

The laminated glass panel is preferably at least partly transparent, more preferably totally transparent. By *"transparent"* is meant that a total transmittance (direct and diffuse) greater than 1 %, preferably greater than 40 %, is achieved for wavelengths that are visible by the human eye (between 350 and 800 nm) from a discrete and/or continuous spectrum. In some embodiments, the laminated glass panel may be tinted in its thickness, over all or a part of its surface.

The laminated glass panel comprises two main surfaces which are opposite and corresponds to the (outer) faces of the laminated glass panel having the largest area. The thickness of the laminated glass panel (between its two main surfaces) may be from 1.5 mm to 40 mm, preferably from 3.58 mm to 12.86 mm.

The laminated glass panel may have any shape, and has preferably a quadrilateral shape, in particular a rectangular shape or a substantially rectangular shape, or a trapezoidal shape or a substantially trapezoidal shape. Alternatively, the laminated glass panel may have a circular shape or a substantially circular shape or an elliptical shape or a substantially elliptical shape.

The glazing unit of the invention comprises an array of piezoelectric patches placed on at least one on the main surfaces of the laminated glass panel. A piezoelectric patch comprises a piece of piezoelectric material placed between two electrodes. The piezoelectric patch is able to convert an electrical signal into a mechanical movement and vice-versa. When the soundwaves reach the laminated glass panel, they cause a deformation of the glass panel. The piezoelectric patches, that are able to deform, absorb said deformation while producing electricity.

Each of the piezoelectric patch is connected to a respective loading circuit, i.e. each loading circuit is connected to a single piezoelectric patch (in other terms, two piezoelectric patches are not connected to the same loading circuit). Each of the piezoelectric patch is connected to a single loading circuit.

Each piezoelectric patch connected to one loading circuit is equivalent to a mass/spring system that can be lightweight and can be transparent. For each piezoelectric patch connected to a circuit, the sound transmission loss is increased for a frequency band around the resonance frequency of the piezoelectric patch/circuit system (this phenomenon is also called *"STL peak"* in the present text, the STL increasing with frequency until a maximum achieved at approximately the resonance frequency of the piezoelectric patch/circuit system and then decreasing). The plurality of such piezoelectric patch/circuit systems, periodically distributed, turns the laminated glass panel into a metamaterial and produces a band gap in which the acoustic insulation is improved, at the anti-resonance frequency of the metamaterial. The start and end frequencies of the band gap of the metamaterial can be tuned by changing the resonance of the piezoelectric patches.

In the present text, unless stated otherwise, the term "*STL peak*" will be used to refer to the peak of STL achieved for one (each) single piezoelectric patch (at its resonance frequency) whereas the peak of STL achieved for the whole metamaterial (at its anti-resonance frequency) will be referred to as "*STL peak at the anti-resonance frequency*" or "*STL peak of the metamaterial*". This STL peak at the anti-resonance frequency of the metamaterial is due to the band gap produced by the metamaterial.

The piezoelectric patches may be fixed to the laminated glass panel by glue and/or by using printing technologies.

Preferably, at least some of the piezoelectric patches are transparent, more preferably all the piezoelectric patches are transparent. In such advantageous embodiments, the field of vision is not impaired.

The piezoelectric material of all patches or each patch independently may comprise or be zinc oxide, titanium and barium oxide $BaTiO_3$, aluminum nitride, lead zirconate titanate (PZT), polyvinylidene fluoride (PVDF), lead zirconate titanate doped with lanthanum (PZTL) and/or a poly(styrene-b-isoprene) block copolymer.

The electrodes may comprise or be made of a conductive oxide, preferably transparent, such as titanium oxide, or a metal, and may be a conductive and transparent coating, or a metal grid (preferably an invisible micro metal grid).

The piezoelectric patches are periodically positioned on the surface(s) of the laminated glass panel so that the laminated glass panel with the piezoelectric patches forms a metamaterial. The periodic arrangement of the piezoelectric patches makes it possible to create a band gap, i.e. a frequency band in which sound waves and elastic waves cannot pass through the glazing unit and are all reflected or decayed.

The piezoelectric patches advantageously have a thickness (i.e. the dimension of the patch along a direction perpendicular of the main surface of the laminated glass panel on which the patch is placed) of from 2 $\mu$m to 2 mm, preferably from 10 $\mu$m to 500 $\mu$m, more preferably from 10 $\mu$m to 200 $\mu$m. In some embodiments, the thickness of the piezoelectric patches may be from 2 to 10 $\mu$m, or from 10 to 20 $\mu$m, or from 20 to 50 $\mu$m, or from 50 to 100 $\mu$m, or from 100 to 200 $\mu$m, or from 200 to 300 $\mu$m, or from 300 to 400 $\mu$m, or from 400 to 500 $\mu$m, or from 500 to 600 $\mu$m, or from 600 to 700 $\mu$m, or from 700 to 800 $\mu$m, or from 800 to 900 $\mu$m, or from 900 $\mu$m to 1 mm, or from 1 to 1.1 mm, or from 1.1 to 1.2 mm, or from 1.2 to 1.3 mm, or from 1.3 to 1.4 mm, or from 1.4 to 1.5 mm, or from 1.5 to 1.6 mm, or from 1.6 to 1.7 mm, or from 1.7 to 1.8 mm, or from 1.8 to 1.9 mm, or from 1.9 to 2 mm. When the thickness increases, the amplitude of the STL peak increases.

The piezoelectric patches may have any suitable shape. For example, the piezoelectric patches may have a transverse cross-section (*i.e.* transverse to the direction of its thickness) having a rectangular shape or a substantially rectangular shape, such as a square shape or a substantially square shape, or may have a transverse cross-section having a triangular shape or a substantially triangular shape, or may have a transverse cross-section having a hexagonal shape or a substantially hexagonal shape. Preferably, the piezoelectric patches have a transverse cross-section having a rectangular shape or a substantially rectangular shape, such as a square shape or a substantially square shape.

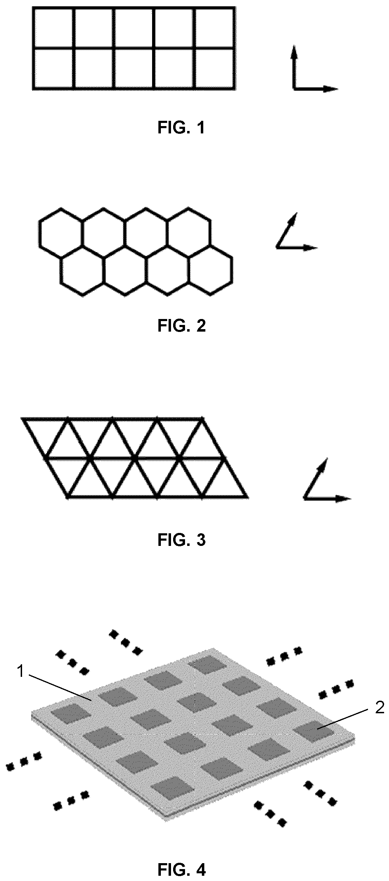

The piezoelectric patches may be arranged according to any suitable pattern, provided that they form a periodic array. In particular, the piezoelectric patches may be arranged according to a rectangular (primitive orthorhombic) lattice or to a square (tetragonal) lattice or to a hexagonal lattice. For example, when the piezoelectric patches have a transverse cross-section having a square shape (or a rectangular shape), they may be arranged according to a square lattice (or to a rectangular lattice). Such an embodiment is shown in **figure 1.** When the piezoelectric patches have a transverse cross-section having a hexagonal shape, they may be arranged according to a hexagonal shape. Such an embodiment is shown in **figure 2**. When the piezoelectric patches have a transverse cross-section having a triangular shape, they may be arranged so that units consisting of two triangular piezoelectric patches of opposite orientation are arranged according to a hexagonal lattice. Such an embodiment is shown in **figure 3**. Preferably, the piezoelectric patches are arranged according to a rectangular lattice or to a square lattice.

Advantageously, the surface area ratio of the piezoelectric patches to the laminated glass panel main surface (*i.e.* the total surface area ratio of all of the piezoelectric patches on one main surface of the glass panel to the surface area of said main surface) is greater than or equal to 0.15, preferably it is from 0.5 to 1, more preferably from 0.7 to 0.9. In particular, the surface area ratio of the piezoelectric patches to the laminated glass panel may be from 0.15 to 0.3, or from 0.3 to 0.5, or from 0.5 to 0.6, or from 0.6 to 0.7, or from 0.7 to 0.8, or from 0.8 to 0.9, or from 0.9 to 1. When the surface area ratio of the piezoelectric patches to the laminated glass panel main surface increases, the width of the band gap increases and the anti-resonance quality factor of the metamaterial increases (i.e. the width of STL peak of the metamaterial at its anti-resonance frequency increases).

In some embodiments, the distance between two adjacent piezoelectric patches may be from 0.5 to 50 cm, preferably from 1 to 15 cm. The glazing unit may comprise from 10 to 1000 piezoelectric patches per m$^2$, preferably from 10 to 200 piezoelectric patches per m$^2$.

In some embodiments, the glazing unit may comprise, as the piezoelectric patches:

- a first electrode, preferably transparent, in the form of a (thin) layer deposited over all the surface of the laminated glass panel, or a plurality of first electrodes, preferably transparent, in the form of a plurality of portions of (thin) layer periodically distributed over all the surface of the laminated glass panel;
- a piezoelectric material, preferably transparent, in the form of a (thin) layer extending over all the surface of the laminated glass panel, or a plurality of pieces of piezoelectric material, preferably transparent, in the form of a plurality of portions of (thin) layer periodically distributed, wherein each piece of piezoelectric material is placed on the first electrode in the form of a (thin) layer or on one single first electrode in the form of a portion of (thin) layer; wherein the pieces of piezoelectric material are preferably insulated from each other by an electrically insulating material;
- a plurality of second electrodes, preferably transparent, in the form of a plurality of portions of (thin) layer periodically distributed, each second electrode being placed on one single piece of piezoelectric material or above one single first electrode covered by the piezoelectric material in the form of a (thin) layer arranged over all the surface of the laminated glass panel.

Each electrode may consist of a stacking of (thin) layers, preferably comprising at least one (thin) layer in conductive oxide, preferably transparent, for example titanium oxide, and/or a metallic (thin) layer.

At least one dielectric layer may be placed between the first electrode and the piezoelectric material and/or between the second electrode and the piezoelectric material.

The piezoelectric patches are each connected to a loading circuit.

The loading circuits each have at least one negative capacitor. A negative capacitor may be achieved with an Antoniou's circuit.

The negative capacitors of each loading circuit have a negative capacitance $C_n$ in the range of from $-0.7 \times C_p$ to $-0.1 \times C_p$, wherein $C_p$ is the capacitance of the piezoelectric patch to which the loading circuit (comprising the negative capacitor) is connected. The capacitance $C_p$ of the piezoelectric patch is given by the following equation:

[Math.1]

$$C_{\mathrm{p}} = \frac{\varepsilon_{33}^{T} A_{\mathrm{s}}}{h_{\mathrm{p}}}$$

wherein $A_s$ is the surface area of the piezoelectric patch (in a direction perpendicular to its thickness), $h_p$ is the thickness of the piezoelectric patch and $\varepsilon^T_{33}$ is the dielectric constant of the piezoelectric patch. Introducing a negative capacitance in the above-mentioned range, along with a correspondingly tuned inductance, makes it possible to shift the STL valley (induced by the resonance of the metamaterial) to the coincidence-controlled region, where the SLT valley may be tackled by using laminated glass. Indeed, the use of laminated glass makes it possible to reduce or even prevent the drop of STL when it is in the coincidence-controlled region. Moreover, when the negative capacitance is in the above-mentioned range, the STL peak has a sufficient width, making it possible to achieve a broadband sound insulation. The higher the negative capacitance is (in absolute value), the wider the STL peak will be and the farther (towards the high frequencies) the STL peak will be shifted.

Preferably, the negative capacitance $C_n$ is from $-0.6\mathrm{x}C_p$ to $-0.4\mathrm{x}C_p$. The negative capacitance $C_n$ may be from $-0.7\mathrm{x}C_p$ to $-0.65\mathrm{x}C_p$, or from $-0.65\mathrm{x}C_p$ to $-0.6\mathrm{x}C_p$, or from $-0.6\mathrm{x}C_p$ to $-0.55\mathrm{x}C_p$, or from $-0.55\mathrm{x}C_p$ to $-0.5\mathrm{x}C_p$, or from $-0.5\mathrm{x}C_p$ to $-0.45\mathrm{x}C_p$, or from $-0.45\mathrm{x}C_p$ to $-0.4\mathrm{x}C_p$, or from $-0.4\mathrm{x}C_p$ to $-0.35\mathrm{x}C_p$, or from $-0.35\mathrm{x}C_p$ to $-0.3\mathrm{x}C_p$, or from $-0.3\mathrm{x}C_p$ to $-0.25\mathrm{x}C_p$, or from $-0.25\mathrm{x}C_p$ to $-0.2\mathrm{x}C_p$, or from $-0.2\mathrm{x}C_p$ to $-0.15\mathrm{x}C_p$, or from $-0.15\mathrm{x}C_p$ to $-0.1\mathrm{x}C_p$.

Each loading circuit also comprises at least one inductor. The inductor may be a coil or a synthetic inductor and is preferably a synthetic inductor. A synthetic inductor may be achieved with an Antoniou's circuit. The use of a synthesis inductor is advantageous compared to the use of a coil because it takes less place and is lighter.

The inductor of each loading circuit has preferably an inductance $L$ of from 0.25 mH to 100 H, preferably from 0.01 H to 20 H. Together with the introduced negative capacitance, said ranges of inductance make it possible to fix the STL peak in the mass-controlled region, and to shift the STL valley (induced by the resonance of the metamaterial) in the coincidence-controlled region. In some embodiments, the inductance of the inductors may be from 0.25 mH to 1 mH, or from 1 mH to 0.01 H, or from 0.01 to 0.05 H, or 0.05 to 0.1 H, or from 0.1 to 0.5 H, or from 0.5 to 1 H, or from 1 to 2 H, or from 2 to 3 H, or from 3 to 4 H, or from 4 to 5 H, or from 5 to 6 H, or from 6 to 7 H, or from 7 to 8 H, or from 8 to 9 H, or from 9 to 10 H, or from 10 to 11 H, or from 11 to 12 H, or from 12 to 13 H, or from 13 to 14 H, or from 14 to 15 H, or from 15 to 16 H, or from 16 to 17 H, or from 17 to 18 H, or from 18 to 19 H, or from 19 to 20 H.

The inductance $L$ of the inductor may be tuned to have the STL peak at or near a target frequency. The resonance frequency of the piezoelectric patch connected to the circuit, and thus the frequency of the maximum of the STL peak $f_{peak}$ is governed by the following equation:

[Math.2]

$$f_{peak} = \frac{1}{2\pi\sqrt{LC_p}}$$

wherein $L$ is the inductance of the inductor and $C_p$ is the capacitance of the piezoelectric patch.

Preferably, the loading circuits comprise at least one resistor. The resistor makes it possible to dissipate the electricity produced by the piezoelectric patch when it absorbs the deformation of the laminated glass panel.

In other embodiments, the loading circuit does not comprise any resistor. The piezoelectric patch may dissipate the produced electricity through its own resistance.

Each loading circuit may be a passive circuit or a semi-passive circuit. In particular, the loading circuit may be passive when it comprises only one or more coils as inductors and it may be semi-passive when it comprises at least one synthetic component. Indeed, synthetic components (such as negative capacitors and synthetic inductors) can comprise operational amplifiers which need to be powered to work (they need to be supplied with a voltage of around +/-15 V). However, a loading circuit comprising synthetic components may alternatively be a passive circuit if said synthetic components are achieved without using operational amplifiers that need to be powered. In the embodiments wherein the loading circuit contains at least one synthetic component comprising operational amplifiers, the system of the invention is different from active attenuation systems. The piezoelectric patches absorb the deformation of the glass panel in a passive or semi-passive way, as a mass/spring system (which is a passive system) would do. No energy is provided to the system of the invention, which prevents potential instabilities that may occur in an active control system.

The loading circuits may be located on an electronic board, for example placed near the laminated glass panel. The electronic board may be placed in the body of the vehicle or in the structure of the building comprising the glazing unit, for example it may be hidden behind a dashboard or a gypsum board. The loading circuits may all be connected to a central control. The loading circuits may be connected to the piezoelectric patches (and more preferably to their electrodes) by means of two or more electrical wires.

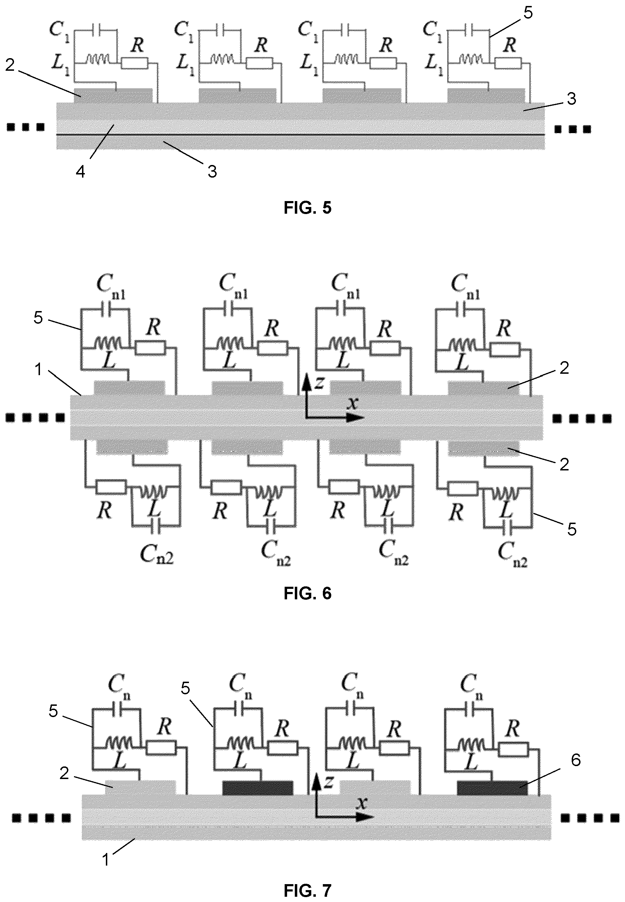

The glazing unit can comprise piezoelectric patches on only one of the main surfaces of the laminated glass panel. Such an embodiment in shown in **figures 4** and **5.** Making reference to these figures, a plurality of piezoelectric patches 2 are placed in a periodic array on one (outer) surface of a laminated glass panel 1, wherein the laminated glass panel 1 comprises two glass sheets 3 between which is inserted a viscoelastic plastic interlayer 4. Making reference to **figure 5,** each piezoelectric patch is connected to a respective circuit 5 comprising a negative capacitor, an inductor and a resistor.

Alternatively, in advantageous embodiments, the glazing unit can comprise an array of piezoelectric patches 2, each piezoelectric patch 2 being connected to a loading circuit 5, on both main surfaces of the laminated glass panel 1, as shown in **figure 6.** More preferably, the piezoelectric patches 2 on one main surface of the laminated glass panel 1 are each opposite a piezoelectric patch 2 on the other main surface. The piezoelectric patches 2 on each main surface of the laminated glass panel 1 may be connected to loading circuits 5 that may be identical or different from each other (for example, they may have a different capacitance, provided that the capacitances $C_n$ of the negative capacitor of the loading circuits connected to the piezoelectric patches of either surface are in the range of from $-0.7 \times C_p$ to $-0.1 \times C_p$, and/or a different inductance and/or a different resistance). Having piezoelectric patches on the two surfaces of the laminated glass panel makes it possible to achieve a better sound insulation performance. In the particular embodiment of **figure 6,** the piezoelectric patches 2 on each main surface of the laminated glass panel 1 are identical but the loading circuits 5 connected to the piezoelectric patches 2 on one surface of the glass panel 1 comprise a negative capacitor having a capacitance $C_{n1}$ different from the capacitance $C_{n2}$ of the negative capacitors of the loading circuits 5 connected to the piezoelectric patches on the other main surface of the laminated glass panel 1.

Whether the piezoelectric patches are arranged on one or two of the main surfaces of the laminated glass panel, they are always on an outer surface of the laminated glass panel. In other terms, they are not placed inside the laminated glass panel, on an inner surface of the glass sheets of the laminated glass panel as disclosed in document WO 2019/229351. Indeed, the viscoelastic plastic interlayer in laminated glass is very thin (generally it has a thickness of 0.8 mm or less) and it is generally not practical to place piezoelectric patches on the inner surfaces of the glass sheets, especially thick piezoelectric patches (for example patches having a thickness higher or equal to 100 $\mu$m).

All the piezoelectric patches and the loading circuits of the glazing unit can be identical (the capacitance, the inductance and the resistance of the loading circuits being identical). This makes it possible to achieve a STL peak of the metamaterial with a higher amplitude.

Alternatively, as for example shown in **figure 7,** the glazing unit may comprise two or more different subarrays of piezoelectric patches 2, 6 connected to a loading circuit 5, wherein all the piezoelectric patches 2, 6 and the loading circuits 5 of each different subarray are identical. This makes it possible to generate several band gaps (at different frequencies), however, the STL peaks of the metamaterial generated by these band gaps will have a lower amplitude than if all the piezoelectric patches and loading circuits of the glazing unit are identical. The piezoelectric patches 2, 6 of each different subarray are periodically arranged on the surface of the laminated glass panel 1. The different subarrays may differ from each other in that the piezoelectric patches 2, 6 of each subarray are different (for example they may have a different capacitance $C_p$). Alternatively, or additionally, the loading circuits 5 connected to the piezoelectric patches 2, 6 of each subarray may be different, for example they may have a different capacitance (provided that the capacitances $C_n$ of the negative capacitor of the loading circuits connected to the piezoelectric patches of each subarray are in the range of from $-0.7 \times C_p$ to $-0.1 \times C_p$) and/or a different inductance and/or a different resistance. In the particular embodiment of **figure 7,** a first subarray of identical piezoelectric patches 2 is periodically arranged on one surface of the laminated glass panel 1 and a second subarray of identical piezoelectric patches 6, different from the piezoelectric patches 2, is periodically arranged on the same surface of the laminated glass panel 1. In this example, the loading circuits 5 of all piezoelectric patches 2, 6 are identical.

The glazing unit may be auto-adaptative to the sound. One or more microphones may be placed on or near the glazing unit (for example they may be integrated on the body of the vehicle or in the structure of the building comprising the glazing unit). The microphones may perform a real-time analysis of the frequency band of the sound/noise and send it to one or more controllers. The controller may automatically tune the inductance and/or the capacitance of the loading circuits in order to shift the STL peak so that the band gap covers the frequency band of the sound/noise. In some embodiments, the glazing unit may have several subarrays of different piezoelectric patches tuned to produce several different STL peak and a smart algorithm method, such as deep learning, can be used to optimize the sound insulation performance of the glazing unit and automatically adapt the glazing unit to different sound environments.

The loading circuits of the glazing unit may comprise two or more capacitors (for example, two, three, four or five capacitors) and/or two or more inductors (for example, two, three, four or five inductors). Advantageously, the capacitors of one loading circuit have a different negative capacitance $C_n$ (provided that each capacitance $C_n$ of the negative capacitors of the loading circuit is in the range of from $-0.7 \times C_p$ to $-0.1 \times C_p$) and/or the inductors of the loading circuit have a different inductance. Preferably, the loading circuits have the same number of capacitors and inductors.

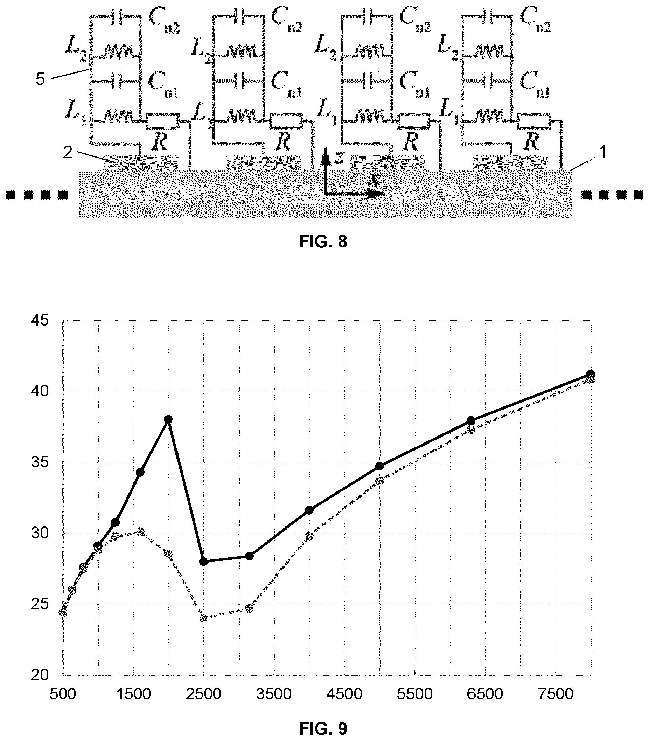

More preferably, the couples of capacitor and inductor are connected in parallel and can work independently. A controller may switch from one couple of capacitor and inductor of the loading circuit to another. This makes it possible to improve the sound transmission loss of the glazing unit for various frequency bands. An example of such an embodiment is shown in **figure 8**. In this example, the laminated glass panel 1 comprises, on one of its main surfaces, an array of identical piezoelectric patches 2, each connected to a loading circuit 5 comprising one resistor, two inductors having respectively an inductance $L_1$ and $L_2$ and two negative capacitors having respectively a negative capacitance $C_{n1}$ and $C_{n2}$.

The loading circuits of the glazing unit may comprise two or more resistors (for example, two, three, four or five resistors). The resistors of one loading circuit may have a different resistance. The loading circuits may comprise a number of resistors equal to or different from the number of capacitors and/or the number of inductors.

Unless stated otherwise, the features described above in connection with the loading circuits, the capacitors, the inductors and the resistors may respectively apply to all or each loading circuit, capacitor, inductor and resistor of the glazing unit independently.

Preferably, the metamaterial glazing unit of the invention is configured to produce a band gap having a start frequency in the mass-controlled region, preferably in a range of from 1 kHz to 2.5 kHz, and an end frequency in the coincidence-controlled region, preferably in a range of from 3.15 kHz to 4 kHz.

In some embodiments, the glazing unit may be used in a double glazing or in a triple glazing. The double glazing may comprise one or two glazing units as described above; the triple glazing may comprise one, two or three glazing units as described above. The piezoelectric patches may be placed on the surface of the glazing unit(s) facing the cavity(ie) of the double glazing or triple glazing and/or on the surface of the glazing unit(s) facing the outside of the double glazing or triple glazing.

The glazing unit according to the invention may be used in any application using glazing units.

In particular, the glazing unit may be a vehicle glazing unit. The vehicle may be any vehicle comprising at least one glazing unit. Preferably, it is a motor vehicle for land transport, although the present invention can also apply to aeronautic vehicles such as helicopters, airplanes and ships. More preferably, the vehicle is an automobile. Alternatively, the vehicle may for example be a truck, a van or a bus.

The glazing unit of the invention may be any vehicle glazing unit. In particular, it may be a windshield, any lateral glazing, for example a door window, a rear window, or the glazing unit of a sunroof.

The glazing unit of the invention may alternatively be a building glazing unit. The glazing unit may be intended to make the interface between the outside and the inside of the building and may for example be a window glazing unit or a façade glazing unit. Alternatively, the glazing unit may be intended to be placed inside the building.

The invention also relates to a method for manufacturing a glazing unit as described above, comprising:

- providing a laminated glass panel;
- fixing a plurality of piezoelectric patches on at least one main surface on the laminated glass panel, wherein the piezoelectric patches are arranged in a periodic array;
- connecting each piezoelectric patch to a loading circuit comprising at least one inductor and at least one negative capacitor having a negative capacitance $C_n$ in the range of from $-0.7 \times C_p$ to $-0.1 \times C_p$.

## Examples

The following examples illustrate the invention without limiting it.

Two laminated glass panels that are 800 mm long, 500 mm wide and 4.5 mm thick were provided. Each on these two glass panels comprised a top sheet of glass having a thickness of 2.1 mm, an interlayer having a thickness of 0.8 mm and a bottom sheet of glass having a thickness of 1.6 mm. The interlayer is either standard PVB (glazing unit No.1) or acoustic PVB (glazing unit No. 2).

An array of about 225 piezoelectric patches having a thickness of 0.1 mm, a length of 40 mm and a width of 40 mm was periodically arranged on the top surface of each laminated glass panel to form a metamaterial. For each laminated glass panel, the surface area ratio of the piezoelectric patches to the top surface of the glass panel surface was 0.9. The piezoelectric patches were made of PZT-5H and each piezoelectric patch had a capacitance $C_p$ of 390 nF. Each piezoelectric patch was connected to a loading circuit comprising an inductor having an inductance of about 0.54 H, a negative capacitor having a capacitance of about -214 nF and a resistor having a resistance of less than 100 ohm. For each glazing unit, the STL peak (generated by the band gap) at the anti-resonance frequency of the glazing unit was tuned to be at the target frequency of 2 kHz and the STL valley (at the resonance frequency) was fixed in the coincidence-controlled region.

For each glazing unit, the STL of the glazing unit in diffuse field was measured as a function of the frequency, according the measurement method defined in standard ISO 10140, when the loading circuits of the piezoelectric patches were in operation and when the loading circuits were cut off ("*open circuits*", the loading circuits are thus not used).

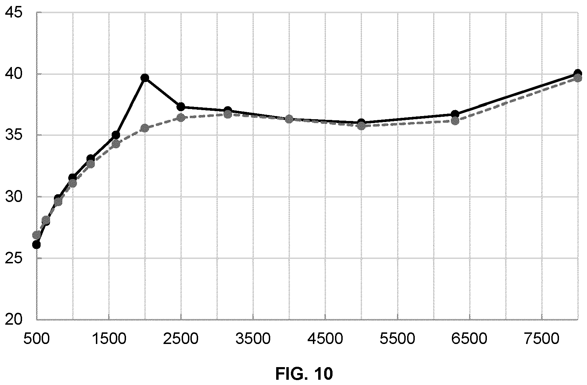

The results are shown in **figures 9** and **10.**

As for glazing unit No. 1 (comprising standard PVB), operating the loading circuits allows an improvement of the sound insulation performance compared to when the circuits are cut off: a significant STL peak at the anti-resonance frequency of the glazing unit was observed around 2 kHz and the STL valley (in the coincidence-controlled region) was reduced.

As for glazing unit No.2 (comprising acoustic PVB), no STL valley was observed and the operating loading circuits made it possible to produce a STL peak at the anti-resonance frequency of the glazing unit in the mass-controlled region.

**Claims**

1. A glazing unit comprising:

   - a laminated glass panel (1) comprising at least two glass sheets (3) between which is inserted at least one interlayer (4) of viscoelastic plastic material;
   - an array of piezoelectric patches (2, 6) periodically arranged on at least one of the main surfaces of the laminated glass panel (1);
   - a plurality of loading circuits (5) each comprising at least one negative capacitor and at least one inductor, wherein each piezoelectric patch (2, 6) is connected to a respective loading circuit (5);

   wherein the negative capacitors of each loading circuit (5) have a negative capacitance $C_n$ in the range of from $-0.7 \times C_p$ to $-0.1 \times C_p$, wherein $C_p$ is the capacitance of the piezoelectric patch (2, 6) to which the loading circuit (5) is connected.

2. The glazing unit of claim 1, wherein the at least one inductor is a synthetic inductor.

3. The glazing unit of claim 1 or 2, wherein the inductor of each loading circuit (5) has an inductance of from 0.25 mH to 100 H, preferably from 0.01 H to 20 H.

4. The glazing unit of any one of claims 1 to 3, wherein each loading circuit (5) comprises at least one resistor.

5. The glazing unit of any one of claims 1 to 4, wherein each loading circuit (5) is a passive circuit or a semi-passive circuit.

6. The glazing unit of any one of claims 1 to 5, wherein the interlayer (4) of viscoelastic plastic material is an interlayer of polyvinyl butyral.

7. The glazing unit of any one of claims 1 to 6, wherein the interlayer (4) of viscoelastic plastic material is an interlayer of acoustic polyvinyl butyral.

8. The glazing unit of any one of claims 1 to 7, wherein the piezoelectric patches (2, 6) are transparent, preferably the laminated glass panel (1) is transparent.

9. The glazing unit of any one of claims 1 to 8, wherein the piezoelectric patches (2, 6) have a thickness of from 2 $\mu$m to 2 mm, preferably from 10 $\mu$m to 200 $\mu$m.

10. The glazing unit of any one of claims 1 to 9, wherein the surface area ratio of the piezoelectric patches (2, 6) to the laminated glass panel (1) main surface is greater than or equal to 0.15, preferably is from 0.7 to 0.9.

11. The glazing unit of any one of claims 1 to 10, wherein the negative capacitance $C_n$ of the negative capacitors of each loading circuit (5) is in the range of from $-0.6 \times C_p$ to $-0.4 \times C_p$.

12. The glazing unit of any one of claims 1 to 11, comprising an array of piezoelectric patches (2, 6) periodically arranged on the two main surfaces of the laminated glass panel (1), preferably the piezoelectric patches (2, 6) on each main surface are placed opposite each other.

13. The glazing unit of any one of claims 1 to 12, wherein all piezoelectric patches (2, 6) and all loading circuits (5) are identical.

**14.** The glazing unit of any one of claims 1 to 12, comprising at least two subarrays of piezoelectric patches (2, 6) each periodically arranged on at least one of the main surfaces of the laminated glass panel (1), wherein the piezoelectric patches (2, 6) of each subarray are identical and connected to identical loading circuits (5) and wherein the piezoelectric patches (2, 6) and/or loading circuits (5) of the different subarrays are different from each other.

**15.** The glazing unit of any one of claims 1 to 14, wherein the loading circuits (5) have at least two negative capacitors of different negative capacitance $C_n$ in the range of from $-0.7 \times C_p$ to $-0.1 \times C_p$ and/or at least two inductors of different inductance.

FIG. 1

FIG. 2

FIG. 3

FIG. 4

FIG. 5

FIG. 6

FIG. 7

**FIG. 8**

**FIG. 9**

FIG. 10

Europäisches
Patentamt

European
Patent Office

Office européen
des brevets

# EUROPEAN SEARCH REPORT

Application Number

EP 21 16 0084

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | WO 2019/229351 A1 (SAINT-GOBAIN GLASS FRANCE [FR]) 5 December 2019 (2019-12-05) * paragraphs [0002], [0040] - [0056], [0064]; figures 1, 2, 4 * | 1-13,15 | INV. H01L41/04 E06B5/20 G10K11/172 |
| Y | US 2018/062062 A1 (DE BONFIM GRIPP JORGE AUGUSTO [BR]) 1 March 2018 (2018-03-01) * paragraphs [0043], [0049], [0050]; figures 1, 7, 8 * | 1-13,15 | |
| Y | GRIPP J A B ET AL: "Adaptive resonant piezoelectric shunt damping enhanced by a synthetic negative capacitance", ISMA 2014, 26TH INTERNATIONAL CONFERENCE ON NOISE AND VIBRATION ENGINEERING, 5-17 SEPTEMBER 2014, LEUVEN, 2014, pages 653-666, XP055829967, * sections 3.4, 4, 5; figures 11-13, 15 * | 1-13,15 | |
| A | WO 2020/002804 A1 (SAINT-GOBAIN GLASS FRANCE [FR]) 2 January 2020 (2020-01-02) * page 3, line 33 - page 7, line 16; figures 1-3 * | 1-15 | TECHNICAL FIELDS SEARCHED (IPC) H01L H02N E06B G10K B32B |

The present search report has been drawn up for all claims

| Place of search | Date of completion of the search | Examiner |
|---|---|---|
| Munich | 4 August 2021 | Köpf, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 16 0084

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2021

| Patent document cited in search report | | Publication date | Patent family member(s) | | Publication date |
|---|---|---|---|---|---|
| WO 2019229351 | A1 | 05-12-2019 | AR | 115453 A1 | 20-01-2021 |
| | | | BR | 112020022499 A2 | 09-02-2021 |
| | | | CN | 112154250 A | 29-12-2020 |
| | | | EP | 3803018 A1 | 14-04-2021 |
| | | | FR | 3081907 A1 | 06-12-2019 |
| | | | KR | 20210015843 A | 10-02-2021 |
| | | | PE | 20210351 A1 | 25-02-2021 |
| | | | US | 2021207430 A1 | 08-07-2021 |
| | | | WO | 2019229351 A1 | 05-12-2019 |
| US 2018062062 | A1 | 01-03-2018 | BR | 102017017725 A2 | 20-03-2018 |
| | | | US | 2018062062 A1 | 01-03-2018 |
| WO 2020002804 | A1 | 02-01-2020 | AR | 115653 A1 | 10-02-2021 |
| | | | CN | 110870330 A | 06-03-2020 |
| | | | FR | 3083165 A1 | 03-01-2020 |
| | | | WO | 2020002804 A1 | 02-01-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019229351 A